# EUROPEAN PATENT APPLICATION

(11) **EP 4 734 154 A1**
(43) Date of publication of application: **29.04.2026**
(21) Application number: 24826305.5
(22) Date of filing: 21.06.2024
(51) Int. Cl.: H01L 21/677, H01L 21/683, H01L 21/687

(54) **WAFER TRANSFER DEVICE**

(30) Priority: 23.06.2023 KR 20230081477; 22.09.2023 KR 20230127144
(71) Applicant: Semics Inc., Gwangju-si, Gyeonggi-do 12800 (KR)
(72) Inventor: KANG, Kun Su, Seoul 05640 (KR); MOON, Hohyeon, Anyang-si, Gyeonggi-do 13924 (KR)
(74) Representative: Pestalozzi, Deborah
(86) International application number: PCT/KR2024/008617
(87) International publication number: WO 2024/262990

(57) **Abstract**

Disclosed is a wafer transfer device. The wafer transfer device for transferring a wafer disposed in a loader to a stage according to the embodiment of the present disclosure may include: a first arm configured to allow the wafer to be loaded thereon and to transfer the wafer from the loader to the stage; a second arm configured to allow the wafer to be loaded thereon and to transfer the wafer from the stage to the loader; and a transfer configured to be disposed above the first arm and the second arm and to have a transfer base which moves between the loader and the stage and lifts the wafer in a non-contact manner by spraying a fluid in a state where the first arm or the second arm is disposed therebelow so that the wafer is spaced apart from the first arm or the second arm.

## Description

### Technical Field

The present disclosure relates to a wafer transfer device, and more particularly to a wafer transfer device for transferring a wafer disposed on a loader to a stage on which a test, etc., is performed.

### Related Art

With the reduction of the thickness of a wafer, the occurrence of warpage increases. Therefore, if the wafer has a thickness equal to or less than a certain level, it is difficult to load the wafer on a chuck by a bottom handling method in which an arm performs transfer at the bottom of the wafer.

In order to solve this problem, there are methods being introduced such as a method of using a top handling arm which lifts and transfers a wafer in a non-contact manner by spraying a fluid such as an inert gas or compressed dry air (CDA), etc., onto the top surface of the wafer using the Bernoulli principle, a method of transferring a wafer using a folding-type wafer transfer, etc.

However, since the method of using the top handling arm does not include additional safety device, there may occur a problem in a fluid supply line, and if the pressure of the fluid drops, there is a risk that a wafer drop accident occurs. Meanwhile, if the folding-type wafer transfer is used, a swing-up operation of the wafer transfer is required in the process of loading the wafer, and thus a chuck must be displaced forward or backward. As a result, there is a problem that the loading time of the wafer is increased and the production efficiency is reduced.

(Prior Art Document) Korean Patent No. 1980137, "Wafer Transfer Robot" (registered on May 14, 2019)

### DISCLOSURE

### TECHNICAL PROBLEM

The purpose of the embodiment of the present disclosure is to solve the above-mentioned problems and is to provide a wafer transfer device capable of avoiding the risk of wafer drop while using a top handling method of transferring a wafer in a non-contact manner by spraying a fluid onto the top surface of the wafer when transferring the wafer.

Another purpose of the present disclosure is to provide a wafer transfer device having a structure capable of handling a wafer from above can move between a loader and a stage in a horizontal direction, so that it has high space efficiency.

The technical problem to be overcome in this document is not limited to the above-mentioned technical problems. Other technical problems not mentioned can be clearly understood from those described below by a person having ordinary skill in the art.

### TECHNICAL SOLUTION

According to an aspect of the present disclosure, a wafer transfer device for transferring a wafer disposed in a loader to a stage includes: a first arm configured to allow the wafer to be loaded thereon and to transfer the wafer from the loader to the stage; a second arm configured to allow the wafer to be loaded thereon and to transfer the wafer from the stage to the loader; and a transfer configured to be disposed above the first arm and the second arm and to have a transfer base which moves between the loader and the stage and lifts the wafer in a non-contact manner by spraying a fluid in a state where the first arm or the second arm is disposed therebelow so that the wafer is spaced apart from the first arm or the second arm.

Here, the transfer base may move on a horizontal plane when moving from the loader to the stage or from the stage to the loader.

Also, the transfer may be fixedly disposed in the loader.

Also, the stage may include a chuck on which the wafer is disposed, and the chuck may be displaced in a vertical direction during the transfer of the wafer.

Also, the transfer may further include a transfer arm which is disposed to rotate on a horizontal plane about a fixed shaft disposed in a vertical direction and has an end to which the transfer base is connected, and an actuator configured to rotate the transfer arm.

Also, the fixed shaft and the actuator may be fixedly disposed in the loader.

Also, the transfer arm may be equipped with a guide formed in a longitudinal direction thereof such that a tube transferring a fluid supplied to the transfer base is disposed.

Also, when the wafer is transferred from the loader to the stage, the first arm may load the wafer thereon and may move from the loader to the stage, and the transfer base may move together with the first arm from the loader to the stage and may lift the wafer from the first arm by spraying the fluid.

Also, when the wafer is transferred from the stage to the loader, the transfer base may spray the fluid from above a chuck of the stage and may lift the wafer from the chuck, and the second arm may move from the loader to the stage, may load the wafer thereon, and may move from the stage to the loader.

### Advantageous Effects

The wafer transfer device according to an aspect of the present disclosure may not only perform the top handling but also avoid the risk of wafer drop, through a combination of the arm which loads the wafer thereon and the transfer which handles the wafer in a non-contact manner above the arm.

The wafer transfer device according to an aspect of the present disclosure prevents the horizontal movement of the chuck from being required during the transfer of the wafer, through the structure in which the transfer handling the wafer from above is disposed to move on the horizontal plane, thereby improving the efficiency of the wafer manufacturing process.

The wafer transfer device according to an aspect of the present disclosure is capable of minimizing an arrangement space of the transfer handling the wafer from above, thereby improving the space efficiency of the wafer transfer device.

The effect of the present disclosure is not limited to the above effects and should be construed as including all the effects that can be inferred from the configuration of the present disclosure disclosed in the detailed description or claims of the present disclosure.

### BRIEF DESCRIPTION OF THE DRAWINGS

FIG. 1 is a view schematically showing a configuration of a wafer transfer device according to an embodiment of the present disclosure.
FIG. 2 is a view showing a detailed configuration of a transfer of the wafer transfer device according to the embodiment of the present disclosure.
FIG. 3 is a view showing a bottom surface of a transfer base of the wafer transfer device according to the embodiment of the present disclosure.
FIG. 4 is a view showing a state in which the transfer of the wafer transfer device according to the embodiment of the present disclosure is disposed at a first position.
FIG. 5 is a view showing a state in which the transfer of the wafer transfer device according to the embodiment of the present disclosure is disposed at a second position.
FIG. 6 is a view showing a loading process of the wafer by the wafer transfer device according to the embodiment of the present disclosure.
FIG. 7 is a view showing an unloading process of the wafer by the wafer transfer device according to the embodiment of the present disclosure.

### MODES OF THE INVENTION

Hereinafter, embodiments of the present disclosure will be described in detail with reference to the accompanying drawings so that those skilled in the art to which the present disclosure pertains can easily implement the present disclosure. The present disclosure may be implemented in various different forms and is not limited to the embodiments described herein. In the drawings, parts irrelevant to the description will be omitted for a clear description of the present disclosure, and the same or similar reference numerals throughout the disclosure may be used for the same or similar components.

It should be noted that the words and terms used in the present specification and the claims are not to be limited to their ordinary or dictionary meanings, but are to be interpreted to conform with the technical idea of the present disclosure under the principle that the inventor can properly define the terms for the best description of the invention made by the inventor.

In the present specification, it should be understood that the term "include" or "comprise" and the like is intended to specify characteristics, numbers, steps, operations, components, parts or any combination thereof which are mentioned in the specification, and intended not to previously exclude the possibility of existence or addition of at least one another characteristics, numbers, steps, operations, components, parts or any combination thereof.

Unless otherwise specified, the fact that a component is "in front of", "behind", "on the side", "above", or "below" another component includes not only a case where a component is disposed "in front of", "on the side", "behind", "above", or "below" another component in direct contact therewith, but also a case where an additional component is interposed therebetween. Also, unless otherwise specified, the fact that a component is "connected" to another component includes not only a case where they are directly connected to each other, but also a case where they are indirectly connected to each other.

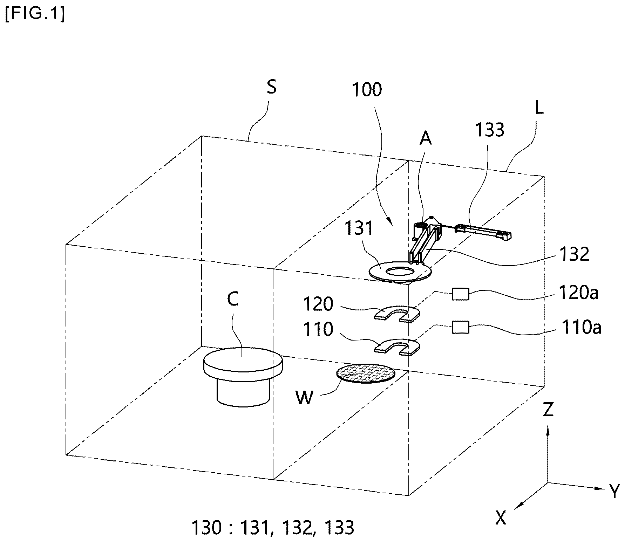

FIG. 1 is a view schematically showing a configuration of a wafer transfer device according to the embodiment of the present disclosure.

A wafer transfer device 100 according to the embodiment of the present disclosure may transfer a wafer W from a loader L to a stage S. More specifically, the wafer transfer device 100 may load the wafer W disposed in the loader L onto a chuck C disposed within the stage S.

Also, the wafer transfer device 100 according to the embodiment of the present disclosure may transfer the wafer from the stage S to the loader L. That is, the wafer transfer device 100 may unload the wafer disposed on the chuck C disposed within the stage S from the chuck C to the loader L.

For example, the wafer W in which a semiconductor pre-process has been completed may be disposed in the loader L. More specifically, a plurality of the wafers arranged in a stack manner within a front opening unified pod (FOUP) may be disposed in the loader L.

Also, a prober may be disposed in the stage S. With respect to the wafer in which a semiconductor pre-process has been completed, the prober determines whether there is a defect by testing the electrical characteristics of a semiconductor chip formed on the wafer, before a post-process is performed.

Referring to FIG. 1, the wafer transfer device 100 according to the embodiment of the present disclosure transfers the wafer W disposed in the loader L to the stage S or transfers the wafer disposed in the stage S to the loader L. The wafer transfer device 100 according to the embodiment of the present disclosure may include a first arm 110, a second arm 120, and a transfer 130.

The first arm 110 may load the wafer thereon, and transfers the wafer W from the loader L to the stage S. The first arm 110 may be displaced in the horizontal direction. That is, the first arm 110 may move in the XY plane during the transfer of the wafer. Also, the first arm 110 may also be displaced in the vertical direction if necessary. In other words, the first arm 110 may also move in the Z-axis direction during the transfer of the wafer.

In summary, the first arm 110 may move in the horizontal direction during the transfer of the wafer. Also, the first arm 110 may also move in the vertical direction during the transfer of the wafer. That is, the first arm 110 may move in the X-axis, Y-axis, and Z-axis directions.

The first arm 110 may include a plate-shaped loading portion capable of loading the wafer thereon. Also, the first arm 110 may suck and hold the wafer. More specifically, the first arm 110 may generate a negative pressure toward a bottom surface of the wafer so that the wafer is pushed into contact with the first arm 110.

The first arm 110 may be driven by a first arm driver 110a. The first arm driver 110a may include one or more joints and an actuator for driving the joints. For example, the actuator of the first arm driver 110a may be a motor.

Also, the first arm driver 110a may include a negative pressure providing means for providing a negative pressure for sucking the wafer onto the first arm 110. For example, the negative pressure providing means may include a pump and a conduit connecting the pump and the first arm 110.

The second arm 120 may load the wafer thereon, and transfers the wafer from the stage S to the loader L. The second arm 120 may be displaced in the horizontal direction. That is, the second arm 120 may move in the XY plane during the transfer of the wafer. Also, the second arm 120 may also be displaced in the vertical direction if necessary. In other words, the second arm 120 may also move in the Z-axis direction during the transfer of the wafer.

That is to say, the second arm 120 may move in the horizontal direction during the transfer of the wafer. Also, the second arm 120 may also move in a vertical direction during the transfer of the wafer. That is, the second arm 120 may move in the X-axis, Y-axis, and Z-axis directions.

The second arm 120 may include a plate-shaped loading portion capable of loading the wafer thereon. Also, the second arm 120 may suck and hold the wafer. More specifically, the second arm 120 may generate a negative pressure toward the bottom surface of the wafer so that the wafer is pushed into contact with the second arm 120.

The second arm 120 may be driven by a second arm driver 120a. The second arm driver 120a may include one or more joints and an actuator for driving the joints. For example, the actuator of the second arm driver 120a may be a motor.

Also, the second arm driver 120a may include a negative pressure providing means for providing a negative pressure for sucking the wafer onto the second arm 120. For example, the negative pressure providing means may include a pump and a conduit connecting the pump and the second arm 120.

In the embodiment of the present disclosure, the second arm 120 may be disposed above the first arm 110. In other words, the first arm 110 may be disposed below the second arm 120. Needless to say, this is just an example, and the vertical positional relationship between the first arm 110 and the second arm 120 may change as needed.

The transfer 130 is disposed above the first arm 110 and the second arm 120. The transfer 130 may handle the wafer using a top handling method of handling the wafer in a non-contact manner above the wafer. More specifically, in a state in which the wafer is loaded on the first arm 110 or the first arm 120, if the transfer 130 sprays a fluid from above the wafer, a lifting force is applied to the wafer according to Bernoulli's principle, so that the wafer may be spaced apart from the first arm 110 or the second arm 120 and lifted toward the transfer 130.

Here, the fluid that the transfer 130 sprays onto the top surface of the wafer may be compressed dry air (CDA). Also, the fluid may be an inert gas.

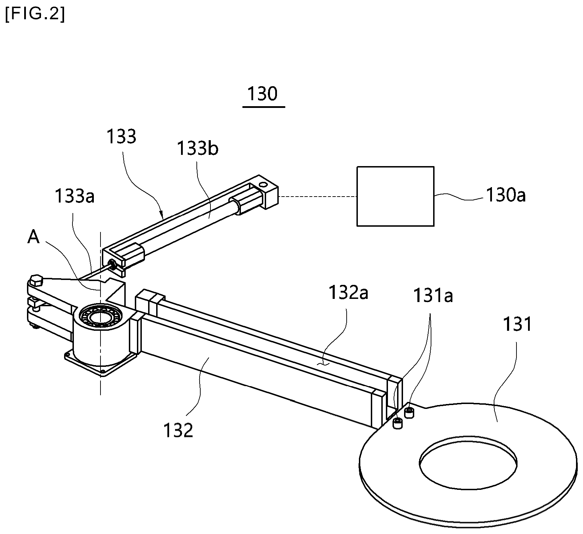

FIG. 2 is a view showing a detailed configuration of the transfer of the wafer transfer device according to the embodiment of the present disclosure.

Referring to FIG. 2, the transfer 130 may include a transfer base 131, a transfer arm 132, and an actuator 133.

The transfer base 131 moves between the loader L and the stage S. The transfer base 131 lifts the wafer in a non-contact manner by spraying the fluid in a state in which the first arm 110 or the second arm 120 is disposed below the transfer base 131, so that the wafer is spaced apart from the first arm 110 or the second arm 120.

The transfer base 131 may have a circular plate shape. The transfer base 131 is supplied with the fluid from the outside and sprays the fluid downward therefrom. The wafer disposed below the transfer base 131 may be subjected to a lifting force by the flow of the fluid and may be lifted upward.

More specifically, the transfer base 131 may have one or more connection portions 131a connected to an external fluid supply tube (not shown). The transfer base 131 may include a hydraulic line for guiding the fluid introduced through the connection portion 131a downward from the transfer base 131.

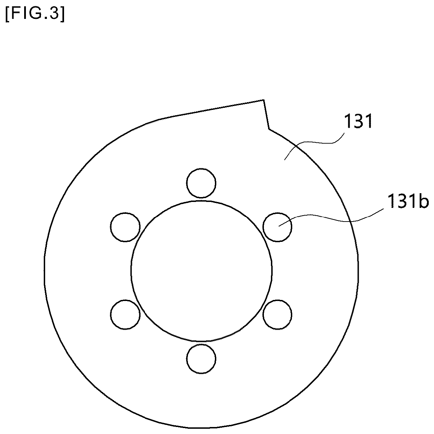

FIG. 3 is a view showing a bottom surface of the transfer base of the wafer transfer device according to the embodiment of the present disclosure.

Referring to FIG. 3, one or more cyclone pads 131b for spraying the fluid may be provided on the bottom surface of the transfer base 131. In the embodiment of the present disclosure, six cyclone pads 131b are arranged spaced apart from each other at a predetermined interval in a circular shape. It goes without saying that this is just an example. The number and arrangement of the cyclone pads 131b may be changed as necessary.

The transfer arm 132 is arranged to rotate on a horizontal plane about a fixed shaft (A) disposed in the vertical direction (Z-axis direction). The transfer base 131 is connected to one end of the transfer arm 132. Meanwhile, the other end of the transfer arm 132 may be rotatably coupled to the fixed shaft (A) and may be connected to the actuator 133.

The transfer arm 132 may include a guide 132a formed in a longitudinal direction thereof such that a fluid supply tube (not shown) for transferring the fluid supplied to the transfer base 131 can be disposed. In the embodiment of the present disclosure, the guide 132a may be formed in the form of a groove having an open top. Also, the guide 132a may be covered by a separate cover. Meanwhile, the guide 132a may have a tubular structure.

The actuator 133 rotates the transfer arm 132. The actuator 133 provides a torque to the transfer arm 132 such that the transfer arm 132 can be pivoted on the fixed shaft (A).

In the embodiment of the present disclosure, the actuator 133 may include a rod 133a and a rod driver 133b. The rod 133a is rotatably coupled to the fixed shaft (A) and is coupled to the other end of the transfer arm 132 having one end to which the transfer base 131 is connected, and is displaced in one direction or the other direction and provides a torque to the transfer arm 132. The rod driver 133b provides a driving force such that the rod 133a is linearly displaced in one direction or the other direction.

For example, the rod driver 133b may include a cylinder that drives the rod 133a by the pressure of the fluid. More specifically, the fluid may be air. That is, the cylinder may be an air cylinder.

Meanwhile, the transfer 130 may further include a control unit 130a for controlling the actuator 133. The control unit 130a may receive a command from an upper control unit and may control the actuator 133.

In the embodiment of the present disclosure, the transfer 130 may move on the horizontal plane. Specifically, the transfer base 131 of the transfer 130 may move on the horizontal plane when moving from the loader L to the stage S and moving from the stage S to the loader L.

Meanwhile, in the embodiment of the present disclosure, the transfer 130 may not have a vertical displacement. For example, the transfer base 131 may move on the XY plane without displacement in the Z-axis direction during the transfer of the wafer.

If the transfer 130 is configured in a folding manner, a swing-up operation is required when the transfer 130 moves and a significant displacement occurs not only in the XY plane but also in the Z-axis direction. Accordingly, when the wafer is loaded on the chuck C of the stage S, interference with the chuck C may occur, and thus it is necessary for the chuck C to be displaced to the front or rear side of the stage S. As a result, there is a problem that the loading efficiency of the wafer is lowered.

However, according to the embodiment of the present disclosure, the transfer 130 may move on the horizontal plane disposed above the chuck C, that is, on the XY plane disposed above the chuck C, and may minimize the displacement in the Z-axis direction. Therefore, the interference with the chuck C disposed in the stage S may be minimized. Accordingly, the displacement of the chuck C can be minimized, and the efficiency of the wafer manufacturing process may be improved.

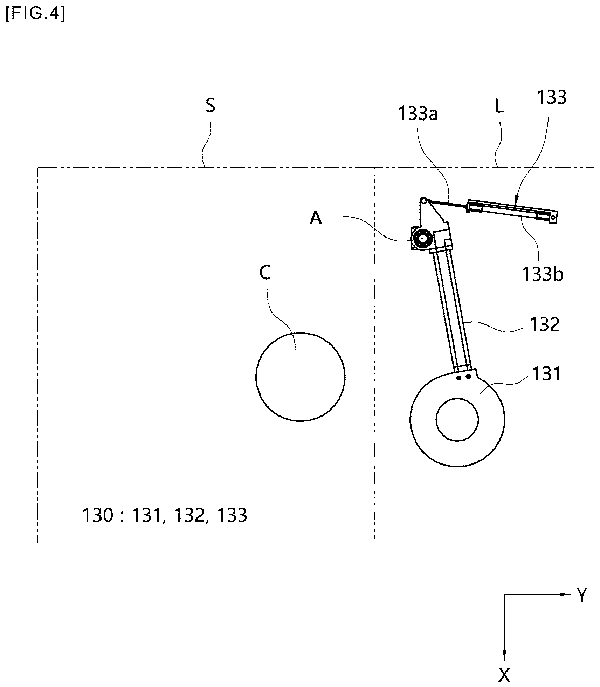

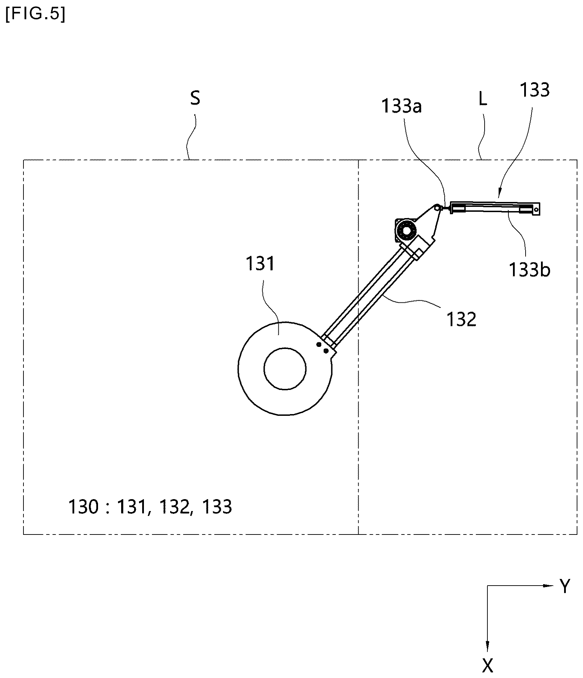

FIG. 4 is a view showing a state in which the transfer of the wafer transfer device according to the embodiment of the present disclosure is disposed at a first position. FIG. 5 is a view showing a state in which the transfer of the wafer transfer device according to the embodiment of the present disclosure is disposed at a second position.

Referring to FIGS. 4 and 5, the first position may be defined as a position at which the transfer base 131 is disposed on the loader L side in such a way as to be spaced apart from the stage S to the maximum extent. The second position may be defined as a position at which the transfer base 131 is disposed above the chuck C of the stage S.

When the transfer base 131 moves from the first position to the second position or from the second position to the first position, the transfer base 131 may move on the horizontal plane. For example, the transfer base 131 may not have a horizontal displacement. That is, the transfer base 131 may move on the XY plane and may not have the displacement on the Z-axis.

Further, in the embodiment of the present disclosure, the transfer arm 132 and the actuator 133 which drive the transfer 130 may also move on the XY plane. Also, the transfer arm 132 and the actuator 133 may minimize the displacement on the Z-axis or may not have the displacement in the Z-axis direction. Here, the XY plane in which the transfer 130 moves may be disposed above the chuck C disposed in the stage S.

Accordingly, when the wafer is loaded on the chuck C of the stage S or unloaded from the chuck C of the stage S to the loader L, interference between the transfer 130 and the chuck C may be avoided. The chuck C disposed in the stage S may minimize the horizontal displacement and may be displaced in a vertical direction if necessary during the transfer of the wafer. As a result, it is possible to minimize the displacement of the chuck C and the time required for the displacement during the loading and unloading processes of the wafer, and to improve the efficiency of the manufacturing process.

Meanwhile, in the embodiment of the present disclosure, the transfer 130 may be fixedly disposed in the loader L. Specifically, the fixed shaft (A) of the transfer 130 and the actuator 133 may be fixedly disposed in the loader.

More specifically, the transfer 130 may be disposed in the upper space of the loader L. As described above, since the transfer 130 has an operating mechanism in which the transfer 30 moves mainly on the XY plane, the transfer 130 requires a smaller arrangement space compared to that of a folding-type transfer. Accordingly, the transfer 130 may be disposed in the upper space of the loader L, which is formed above the first arm 110 and the second arm 120, and the space efficiency may be maximized.

The configuration of the wafer transfer device 100 according to the embodiment of the present disclosure has been described in detail. Hereinafter, an operation process of the transfer device 100 according to the embodiment of the present disclosure will be described.

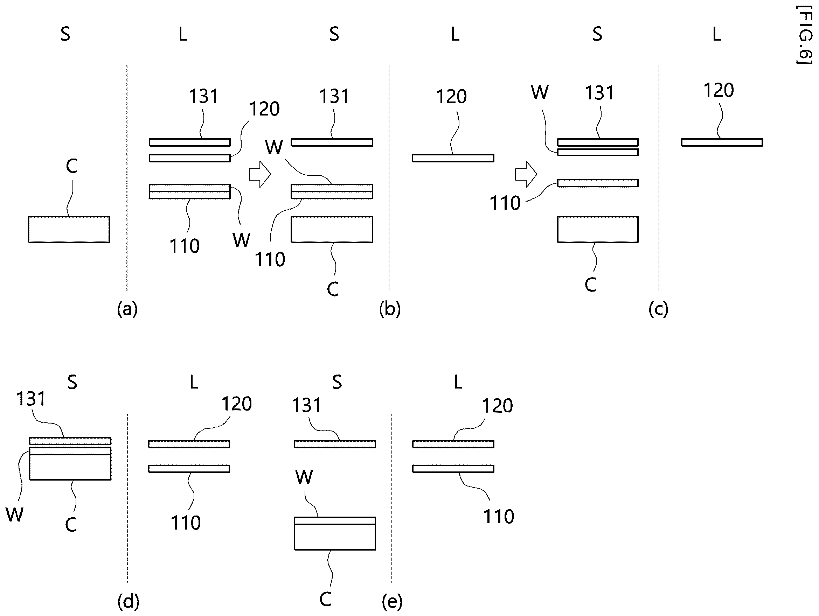

FIG. 6 is a view showing the loading process of the wafer by the wafer transfer device according to the embodiment of the present disclosure. The loading process of the wafer will be described with reference to FIG. 6.

First, in a state in which the wafer W is disposed in the loader L, the first arm 110, the second arm 120, and the transfer base 131 are positioned in the loader L (see (a) of FIG. 6). Here, a semiconductor pre-process may have been completed on the wafer W. Also, a plurality of the wafers arranged in a stack manner within a front opening unified pod (FOUP) may be disposed in the loader L.

Next, the first arm 110 and the transfer base 131 move together to the stage S in a state in which the wafer W is loaded on the first arm 110 (see (b) of FIG. 6). Here, the first arm 110 may hold the wafer W by suction.

Next, the transfer base 131 lifts the wafer W from the first arm 110 by spraying the fluid (see (c) of FIG. 6). Here, the wafer W may not be in contact with the bottom surface of the transfer base 131. That is, the transfer 130 may handle the wafer W in a non-contact manner. Meanwhile, the first arm 110 may move in a vertically upward direction such that handling of the transfer base 131 is easily made.

Next, the first arm 11 leaves the wafer W in the stage S and returns to the loader L, and the chuck C moves in a vertically upward direction to support the wafer W (see (d) of FIG. 6). Here, the transfer 130 may stop the spraying of the fluid. Accordingly, the wafer W may be seated on the chuck C. Also, the chuck C may supply a negative pressure to the bottom surface of the wafer W and sucks the wafer W.

Finally, the chuck C moves in a vertically downward direction (see (e) of FIG. 6). Here, the chuck C may support the wafer W by suction. In the state in which the wafer W is disposed on the chuck C, a test or the like may be performed on the wafer W.

As such, according to the embodiment of the present disclosure, when the wafer W is transferred from the loader L to the stage S, the first arm 110 may load the wafer W thereon and move from the loader L to the stage S, and the transfer base 131 may move together with the first arm 110 from the loader L to the stage S and may lift the wafer W from the first arm 110 by spraying the fluid.

As such, according to the embodiment of the present disclosure, the top handling can be made without a risk that a wafer drop accident occurs during the loading process of the wafer. Also, a wafer having warpage can be effectively handled.

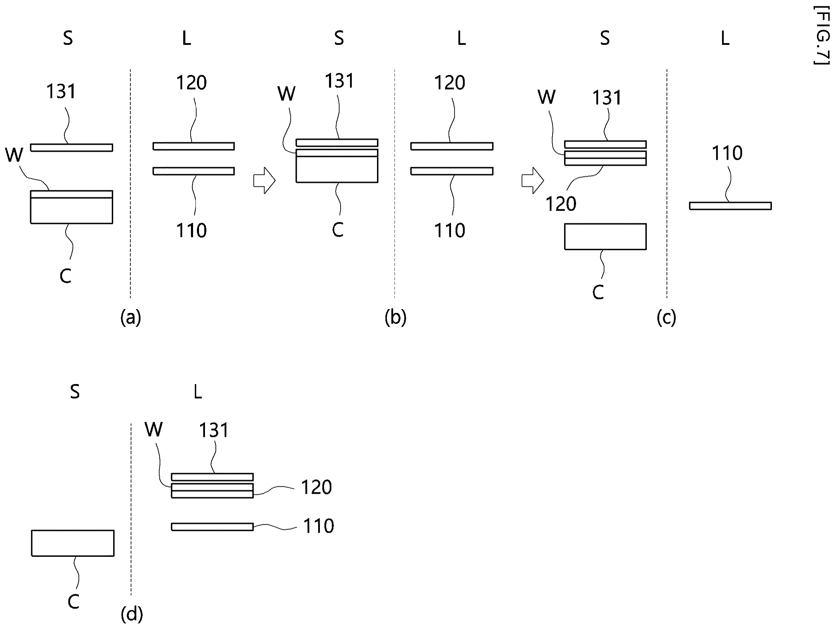

FIG. 7 is a view showing the unloading process of the wafer by the wafer transfer device according to the embodiment of the present disclosure. The unloading process of the wafer will be described with reference to FIG. 7.

First, in a state in which the wafer W is disposed on the chuck C, the transfer base 131 is disposed above the wafer W (see (a) of FIG. 7). Here, a test or the like may have been completed on the wafer W.

Next, the chuck C moves in a vertically upward direction and brings the wafer W close to the transfer base 131, and the transfer base 131 lifts the wafer W by spraying the fluid (see (b) of FIG. 7). Here, the chuck C stops the supply of the negative pressure, thereby allowing the wafer W to be lifted toward the transfer base 131.

Next, in a state in which the transfer base 131 is holding the wafer W in a non-contact manner by spraying the fluid, the second arm 120 enters below the wafer W and loads the wafer W (see (c) of FIG. 7). Here, the transfer base 131 stops the spraying of the fluid, and the second arm 120 may supply a negative pressure below the wafer W, thereby holding the wafer W by suction.

Finally, in a state in which the wafer W is loaded on the second arm 120, the second arm 120 and the transfer base 131 move together from the stage S to the loader L (see (d) of FIG. 7). Here, the second arm 120 may hold the wafer W by suction.

As such, according to the embodiment of the present disclosure, when the wafer W is transferred from the stage S to the loader L, the transfer base 131 may spray the fluid from above the chuck C of the stage S and may lift the wafer W from the chuck C, and the second arm 120 may move from the loader L to the stage S and may load the wafer W thereon and may move from the stage S to the loader L.

As such, according to the embodiment of the present disclosure, the top handling can be made without a risk that a wafer drop accident occurs during the unloading process of the wafer. Also, a wafer having warpage can be effectively handled.

As described above, the wafer transfer device according to the embodiment of the present disclosure not only uses the top handling method of transferring the wafer in a non-contact manner by spraying the fluid onto the top surface of the wafer when transferring the wafer but also avoids the risk of wafer drop during the loading and unloading processes of the wafer.

More specifically, the embodiment of the present disclosure allows the top handling without the risk of wafer drop to be made through a combination of the first arm 110 and the second arm 120 which load the wafer thereon and the transfer 130 which handles the wafer in a non-contact manner above the first arm 110 and the second arm 120.

Also, the wafer transfer device according to the embodiment of present disclosure provides high space efficiency through the structure in which the component capable of handling the wafer from above moves between the loader and the stage in the horizontal direction. Also, the wafer transfer device according to the embodiment of the present disclosure prevents the horizontal movement of the chuck from being required during the transfer of the wafer, thereby improving the efficiency of the wafer manufacturing process.

Although the embodiments of the present disclosure have been described, the spirit of the present disclosure is not limited by the embodiments presented in the present specification, and those skilled in the art who understand the spirit of the present disclosure may easily propose other embodiments by adding, changing, deleting, adding, or the like components within the scope of the same spirit, but it will also be said that they are within the spirit of the present disclosure.

## Claims

1. A wafer transfer device for transferring a wafer disposed in a loader to a stage, the wafer transfer device comprising:
a first arm configured to allow the wafer to be loaded thereon and to transfer the wafer from the loader to the stage;
a second arm configured to allow the wafer to be loaded thereon and to transfer the wafer from the stage to the loader; and
a transfer configured to be disposed above the first arm and the second arm and to have a transfer base which moves between the loader and the stage and lifts the wafer in a non-contact manner by spraying a fluid in a state where the first arm or the second arm is disposed therebelow so that the wafer is spaced apart from the first arm or the second arm.

2. The wafer transfer device of claim 1, wherein the transfer base moves on a horizontal plane when moving from the loader to the stage or from the stage to the loader.

3. The wafer transfer device of claim 1, wherein the transfer is fixedly disposed in the loader.

4. The wafer transfer device of claim 1,
wherein the stage comprises a chuck on which the wafer is disposed, and
wherein the chuck is displaced in a vertical direction during the transfer of the wafer.

5. The wafer transfer device of claim 1, wherein the transfer further includes:
a transfer arm which is disposed to rotate on a horizontal plane about a fixed shaft disposed in a vertical direction and has an end to which the transfer base is connected; and
an actuator configured to rotate the transfer arm.

6. The wafer transfer device of claim 5, wherein the fixed shaft and the actuator are fixedly disposed in the loader.

7. The wafer transfer device of claim 5, wherein the transfer arm is equipped with a guide formed in a longitudinal direction thereof such that a tube transferring a fluid supplied to the transfer base is disposed.

8. The wafer transfer device of claim 1, wherein, when the wafer is transferred from the loader to the stage, the first arm loads the wafer thereon and moves from the loader to the stage, and the transfer base moves together with the first arm from the loader to the stage and lifts the wafer from the first arm by spraying the fluid.

9. The wafer transfer device of claim 1, wherein, when the wafer is transferred from the stage to the loader, the transfer base sprays the fluid from above a chuck of the stage and lifts the wafer from the chuck, and the second arm moves from the loader to the stage, loads the wafer thereon, and moves from the stage to the loader.
